# EUROPÄISCHE PATENTSCHRIFT

(11) **EP 0 337 257 B1**
(45) Veröffentlichungstag und Bekanntmachung des Hinweises auf die Patenterteilung: **19.01.1994**
(21) Anmeldenummer: 89105918.0
(22) Anmeldetag: 05.04.1989
(51) Int. Cl.: G03F 7/004

(54) **Positiv arbeitendes, strahlungsempfindliches Gemisch auf Basis von säurespaltbaren und photochemisch säurebildenden Verbindungen und Verfahren zur Herstellung von Reliefmustern und Reliefbildern**
Light photosensitive positive compounds obtained from cleavable and photochemical acid compounds and process for obtaining relief patterns and images
Compositions photosensibles positives à base de composés décomposables par l'acide et de composés formant des acides par voie photochimique et procédé de fabrication d'images et de modèles en relief

(30) Priorität: 14.04.1988 DE 3812326
(43) Veröffentlichungstag der Anmeldung: 18.10.1989
(73) Patentinhaber: BASF Aktiengesellschaft, 67063 Ludwigshafen (DE)
(72) Erfinder: Schwalm, Reinhold, Dr., D-6706 Wachenheim (DE); Binder, Horst, D-6840 Lampertheim (DE); Schuhmacher, Rudolf, Dr., D-6737 Boehl-Iggelheim (DE)

(56) Entgegenhaltungen:
- EP-A- 0 153 682
- EP-A- 0 297 443
- DE-A- 3 628 046
- JP-A-62 038 450
- JOURNAL OF IMAGING TECHNOLOGY. vol. 11, no. 4, August 1985, SPRINGFIELD US Seiten 146 - 157; S.P.Papas: "Photogeneration of Acid: Pat 6- A Review of Basic Principles for Resist Imaging Applications "

## Beschreibung

Die Erfindung betrifft positiv arbeitende, strahlungsempfindliche Gemische, die (a) ein wäßrig-alkalisch lösliches Bindemittel und (b) eine Verbindung enthalten, die mindestens eine durch Säure spaltbare Bindung enthält und unter Einwirkung von Strahlung eine starke Säure bildet, wobei die Löslichkeit der Verbindung (b) in einem wäßrig-alkalischen Lösungsmittel durch die Einwirkung der Säure erhöht wird. Diese Gemische sind sensitiv gegenüber UV-, Elektronen- und Röntgenstrahlung und eignen sich besonders als Resistmaterialien.

Positiv arbeitende strahlungsempfindliche Gemische sind bekannt, und besonders positiv arbeitende Resistmaterialien, die o-Chinondiazide als Löslichkeitsinhibitoren in wäßrig-alkalisch löslichen Bindemitteln, z.B. Novolaken, enthalten, werden kommerziell als Fotoresiste eingesetzt. Die Empfindlichkeit dieser Systeme gegenüber Strahlung ist jedoch teilweise unbefriedigend.

Eine drastische Empfindlichkeitserhöhung in strahlungsempfindlichen Systemen erhält man, wenn man in der Primärphotoreaktion eine Spezies erzeugt, die dann unabhängig von der Strahlung eine katalytische Sekundärrekation auslöst und dadurch die Quantenausbeute auf Werte oberhalb 1 steigert.

Solche Systeme, die photochemisch eine starke Säure erzeugen, die dann in einer Sekundärreaktion säurelabile Gruppen spalten, sind z.B. aus US-A- 3,923,514 und US-A- 3,915,706 für positiv arbeitende Polyaldehyde bekannt.

Weiterhin sind strahlungsempfindliche Gemische auf Basis von säurespaltbaren Verbindungen bekannt, die als Bindemittel ein wäßrig-alkalisch lösliches Polymer, sowie eine Verbindung, die photochemisch eine starke Säure bildet und eine weitere Verbindung, die durch Säure spaltbare Bindungen besitzt, enthalten (DE-A- 3 406 927). Solche 3-Komponentensysteme sind auch aus der Literatur als Röntgenresiste bekannt (K. Dössel u.a. , Microcircuit Engineering, Interlaken 1986). Diese Gemische sind dadurch gekennzeichnet daß das Bindemittel ein Polymerisat mit Alkenylphenoleinheiten enthält. Die Kombination dieser phenolischen Polymerisate mit Novolaken als Bindemittel wird als nicht geeignet beschrieben.

Auch die in der DE-A- 2 322 230 beschriebenen lichtempfindlichen Systeme, die verschiedene lichtempfindliche Verbindungen, z.B. o-Chinondiazide, und Polyvinylphenole sowie Novolake als Bindemittel enthalten, haben bisher keinen Eingang in die Praxis gefunden.

Einen Überblick über die Verwendung von Novolaken in Positiv Resists gibt T. Pampalone in "Solid State Technology, June 1984, Seiten 115 bis 120". Darin wird gezeigt, daß Polymerisate auf Basis von Polyhydroxystyrol weniger geeignet sind, da sie einen unakzeptabel hohen Abtrag aufweisen.

Die Verwendung von Novolaken auf Basis von p-Kresol-Formaldehyd-Harzen für die Deep-UV Lithographie zeigt E. Gipstein in "J. Electrochemical Soc., 129, 1, Seiten 201 bis 205 (1982). Die Verwendung von reinen Novolaken auf Basis p-Kresol hat jedoch den Nachteil, daß die Erweichungsbereiche relativ niedrig liegen.

Photoreaktive Komponenten für die Deep-UV Lithographie sind z.B. solche, die in der DE-A- 3 721 740 vorgeschlagen werden.

Aufgabe der vorliegenden Erfindung war es, neue strahlungsempfindliche Systeme mit hoher Photoreaktivität für die Herstellung von Reliefstrukturen zur Verfügung zu stellen, die im kurzwelligen UV-Bereich unterhalb 300 nm, dem sogenannten Deep-UV belichtbar sind.

Es wurde nun gefunden, daß man vorteilhaft Bindemittel auf Basis von Polyvinylphenolen für die Belichtung im Deep-UV Bereich einsetzen kann, wenn man bis zu 40 Gew.% Novolake auf Basis von p-Alkylphenol-Formaldehydharzen in Kombination mit bis zu 20 Gew.% fotoreaktiven Verbindungen auf Basis von Sulfoniumsalzen, welche im Molekül säurelabile Gruppen aufweisen, verwendet.

Diese Gemische sind ideal für die Belichtung im Deep-UV-Bereich, besonders bei Belichtung mit einem Excimer-Laser der Wellenlänge 248 nm, geeignet, da die optische Dichte dieser Bindemittel wesentlich unter 1 pro Mikrometer Schichtdicke beträgt. Weiterhin zeigen die Gemische sehr hohe Empfindlichkeit, da die Photoreaktion durch eine katalytische Sekundärreaktion unterstützt wird, die die Quantenausbeute auf Werte oberhalb 1 erhöht.

Gegenstand der vorliegenden Erfindung ist ein strahlungsempfindliches Gemisch, das
(a) ein in Wasser unlösliches, in wäßrig-alkalischen Lösungen lösliches oder zumindest dispergierbares polymeres Bindemittel und
(b) eine organische Verbindung, deren Löslichkeit in einem wäßrig-alkalischen Entwickler durch Einwirkung von Säure erhöht wird und die mindestens eine durch Säure spaltbare Gruppierung, sowie zusätzlich eine weitere Gruppierung, die unter der Einwirkung von Strahlung eine starke Säure erzeugt, enthält, und dadurch gekennzeichnet ist, daß das polymere Bindemittel (a) ein Gemisch aus einem Bindemittel auf Basis von Polyvinylphenolen mit einem Molekulargewicht im Bereich von 1 000 bis 250 000 und einem Harz vom Novolaktyp im Molekulargewichtsbereich von 300 bis 20 000 enthält, und die Verbindung (b) ein Sulfoniumsalz der allgemeinen Formel (I) ist 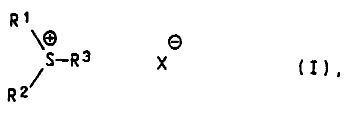 worin R¹ bis R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält und X^{⊖} ein nichtnucleophiles Gegenion bedeutet.

Vorzugsweise ist das phenolische Polymerisat der Komponente (a) Poly-(p-hydroxistyrol), Poly-(p-hydroxi-α-methylstyrol) oder ein Copolymeres von p-Hydroxystyrol und p-Hydroxy-α-methylstyrol und das Harz vom Novolaktyp der Komponente (a) ein p-Alkylphenol/Formaldehyd-Novolakharz oder ein überwiegend o,o'-verknüpftes Phenol/Formaldehyd-Novolakharz.

Das erfindungsgemäße strahlungsempfindliche Gemisch enthält vorzugsweise
(a₁) 40 bis 90 Gew.% des phenolischen Polymerisats,
(a₂) 5 bis 40 Gew.% eines Harzes vom Novolaktyp,
(b) 5 bis 20 Gew.% eines Sulfoniumsalzes der Formel (I)
mit der Maßgabe, daß die Summe der unter

(a₁) + (a₂) + (b)

genannten Prozentzahlen 100 ist, und der Feststoffgehalt des Gemisches in einem organischen Lösungsmittel zwischen 5 und 40 Gew.% liegen kann.

Gegenstand der vorliegenden Erfindung ist außerdem ein Verfahren zur Herstellung von Reliefmustern und Reliefbildern, das dadurch gekennzeichnet ist, daß man als lichtempfindliche Beschichtungsmaterialien ein erfindungsgemäßes strahlungsempfindliches Gemisch einsetzt und nach der Belichtung gegebenenfalls auf Temperaturen zwischen 60 und 120°C erhitzt.

Strahlungsempfindliche Gemische gemäß der vorliegenden Erfindung bestehen also aus in Wasser unlöslichen, in wäßrig-alkalischen Lösungsmitteln jedoch löslichen oder zumindest dispergierbaren polymeren Bindemitteln auf Basis eines Gemisches aus Polyvinylphenolen und einem Harz vom Novolaktyp und einer Verbindung, die säurespaltbare Gruppen enthält und bei Bestrahlung eine starke Säure bildet. Dieses strahlungsempfindliche Gemisch wird im allgemeinen als dünner Film auf ein Substrat aufgebracht, zur Entfernung des Restlösungsmittels unter kontrollierten Bedingungen ausgeheizt, bildmäßig belichtet und erneut unter kontrollierten Bedingungen ausgeheizt. Die bildmäßig belichteten Bereiche werden durch diese Behandlung in ihrer Löslichkeit so verändert, daß ein vollständiger Abtrag mit alkalischen oder polaren Lösungsmitteln erfolgt, während die nicht belichteten Bereiche nur geringen Abtrag zeigen.

Diese strahlungsempfindlichen Gemische sind sensitiv gegenüber Röntgen-, Elektronen- und kurzwelligen UV-Strahlen und können durch Zusatz eines Sensibilisators bis in den Bereich des sichtbaren Lichtes sensibilisiert werden.

In der vorliegenden Erfindung werden als Verbindungen (b), welche unter Bestrahlung Säure bilden und säurelabile Gruppen enthalten Sulfoniumsalze der allgemeinen Formel (I) eingesetzt : 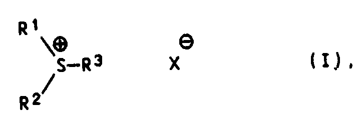
worin R¹ bis R³ untereinander gleich oder verschieden sind und aromatische und/oder aliphatische Reste, die gegebenenfalls Heteroatome enthalten, können, mit der Maßgabe, daß mindestens einer der Reste R¹ bis R³ eine säurespaltbare Gruppe, beispielsweise t-Butylcarbonate von Phenolen bzw. Silylether von Phenolen, enthält. Die vorgenannten säurelabilen Gruppen sind bevorzugt, jedoch können eine große Zahl weiterer säurelabiler Gruppen, wie die bekannten Tetrahydropyranylether, Orthoester, Trityl- und Benzylgruppen, sowie t-Butylester von Carbonsäuren ebenfalls verwendet werden. Es können auch zwei oder mehrere Sulfoniumeinheiten im Molekül über die Reste R¹ bis R³ verknüpft sein.

Die anmeldungsgemäßen Bindemittel haben den vorteil, daß sie relativ stabil in Plasma- und reaktiven Ionenätzverfahren sind.

Für die Anwendung in der Deep-UV Lithographie ist es notwendig, daß das strahlungsempfindliche Gemisch sowohl ein phenolisches Polymerisat auf Basis von Polyvinylphenol als auch einen Novolak vom Typ p-Kresol-Formaldehyd oder überwiegend o,o'-verknüpfter Phenol-Formaldehyd enthält, da einer dieser Komponenten allein nicht die erwünschten Eigenschaften ergibt.

Das Polyvinylphenol enthält Einheiten der allgemeinen Formel (II): 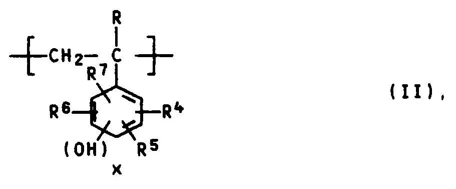
worin R ein Wasserstoff- oder Halogenatom oder eine Alkylgruppe mit 1 bis 4 Kohlenstoffatomen, R⁴, R⁵, R⁶, R⁷ Wasserstoff-, Halogen, Alkyl-oder Alkoxigruppen mit jeweils 1 bis 4 Kohlenstoffatomen bedeuten und x eine Zahl von 1 bis 3, vorzugsweise 1 ist.

Besonders bevorzugt sind solche Polymerisate der Formel (II), bei der R Wasserstoff oder Methyl ist, sowie R⁴ bis R⁷ Wasserstoff und die Hydroxylgruppe in p-Stellung steht.

Diese Polymeren haben im allgemeinen Molekulargewichte (M̅ₙ) im Bereich von 1 000 bis 250 000, bevorzugt 10 000 bis 80 000 und sind mit einem Anteil zwischen 40 und 90, vorzugsweise 60 bis 80 Gew.% im strahlungsempfindlichen Gemisch enthalten.

Als Novolake kommen die bekannten Kresol-Formaldehydtypen oder Phenol-Formaldehydtypen in Frage, wie sie beispielsweise in der US-A 4 377 631 beschrieben sind. Die Synthese der Novolake wird auch z.B. in "A. Knop, L. Pilato; Phenolic Resins, Springer Verlag (1985)" beschrieben.

Für die Anwendung in der Deep-UV Lithographie werden jedoch besonders bevorzugt Typen mit Einheiten der allgemeinen Formel (III) eingesetzt: 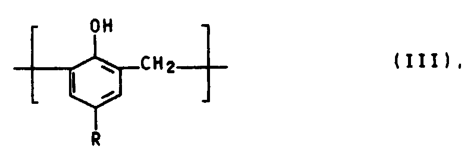
wobei R gleich Wasserstoff oder eine Alkyl-, bevorzugt eine Methylgruppe ist. Geeignet sind diese Novolaktypen im Molekulargewichtsbereich von 300 bis 20 000, bevorzugt von 400 bis 2 000.

Als Verbindungen mit säurespaltbaren Gruppen kommen bevorzugt die in DE-A- 3 721 740 beschriebenen Sulfoniumsalze der allgemeinen Formel (I) in Betracht: 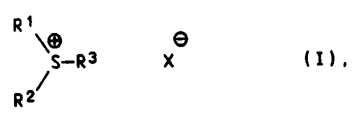
worin R¹-R³ z.B.
4-t-butoxicarbonyloxi-phenyl-
4-t-butoxicarbonyloxi-3,5-dimethyl-phenyl-
4-t-butoxicarbonyloxi-3-methyl-phenyl-
4-t-butoxicarbonyloxi-2-methyl-phenyl-
4-t-butoxicarbonyloxi-3,5-dimethoxi-phenyl-
4-t-butoxicarbonyloxi-3,5-diphenyl-phenyl-
1-t-butoxicarbonyloxi-naphthyl-
4-trimethylsilyl-oxi-phenyl-
4-trimethylsilyl-oxi-naphthyl-
oder R¹ gleich Hydroxiphenyl- und R² und R³ die vorgenannte Bedeutung von R² und R³ haben kann.

Als Gegenionen X^{⊖} kommen bevorzugt komplexe Metallhalogenide, wie Tetrafluorborat, Hexafluoroantimonat, Hexafluoroarsenat und Hexafluorophosphat in Betracht, jedoch ist die Erfindung weder auf diese speziellen Gegenionen noch auf die aufgeführten Verbindungen mit säurespaltbaren Gruppen beschränkt, vielmehr können alle Verbindungen verwandt werden, welche unter Bestrahlung eine starke Säure bilden und im gleichen Molekül eine säurespaltbare Bindung enthalten.

Die erfindungsgemäßen Gemische werden bevorzugt in einem organischen Lösungsmittel gelöst, wobei der Feststoffgehalt im Bereich zwischen 5 und 40 Gew.% liegt. Als Lösungsmittel kommen bevorzugt aliphatische Ketone, Ether und Ester, sowie Mischungen derselben in Frage. Besonders bevorzugt sind Alkylenglykol-monoalkylether, wie beispielsweise Ethyl-cellosolve, Butylglykol, Methyl-cellosolve und 1-Methoxy-2-propanol, Alkylenglykol-alkylether-ester, wie beispielsweise Methyl-cellosolve-acetat, Ethyl-cellosolve-acetat, Methyl-propylen-glykol-acetat und Ethyl-propylenglykol-acetat, Ketone, wie beispielsweise Cyclohexanon, Cyclopentanon und Methyl-ethyl-keton, sowie Acetate, wie Butylacetat und Aromaten, wie Toluol und Xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler, Netzmittel, Farbstoffe und Weichmacher zugesetzt werden.

Gegebenenfalls können auch Sensibilisatoren in geringen Mengen zugesetzt werden, um die Verbindungen im längerwelligem UV- bis hin zum sichtbaren Bereich zu sensibilisieren. Polycyclische Aromaten, wie Pyren und Perylen sind bevorzugt, jedoch können auch andere Farbstoffe, die als Sensibilisatoren wirken, verwendet werden.

Beim erfindungsgemäßen Verfahren zur Herstellung von Reliefmustern wird eine strahlungsempfindliche Aufzeichnungsschicht, die aus dem erfindungsgemäßen strahlungsempfindlichen Gemisch besteht, bildmäßig in solcher Dosis bestrahlt, daß die Löslichkeit der belichteten Bereiche in wäßrig-alkalischen Lösungsmitteln zunimmt und diese bestrahlten Bereiche selektiv mit dem alkalischen Entwickler entfernt werden können. Das Verfahren ist dadurch gekennzeichnet, daß Verbindungen mit säurespaltbaren Gruppen, die gleichfalls unter Bestrahlung eine starke Säure erzeugen, die katalytisch die säurelabilen Gruppen abspaltet und damit die Löslichkeit der Verbindung in alkalischen Entwicklern erhöht, in Kombination mit den erfindungsgemäßen alkalilöslichen Bindemitteln verwendet werden.

Beispielsweise werden die polymeren Bindemittel (= Gemisch aus Polyvinylphenol und Novolakharz) und 5 bis 20 Gew.% eines Sulfoniumsalzes, bezogen auf das Bindemittel, in Methyl-glykol-acetat oder Methyl-propylenglykol-acetat gelöst, wobei der Feststoffgehalt zwischen 10 und 30 Gew.% betragen kann. Die Lösung wird zweckmäßigerweise durch ein Filter mit einem Porendurchmesser von 0.2 µm filtriert. Durch Aufschleudern der Resistlösung bei Umdrehungszahlen zwischen 1 000 und 10 000 U/Minute kann so ein Resistfilm auf einem Siliziumwafer erzeugt werden. Der Wafer wird dann üblicherweise zwischen 1 und 5 Minuten bei 90°C bzw. 80°C ausgeheizt. Die so erhaltenen Filme werden durch eine chrombeschichtete, strukturierte Ouarzmaske mit UV-Licht einer Quecksilber-Hochdrucklampe, oder mit Excimer-Laserlicht der Wellenlänge 248 nm bestrahlt. Die bestrahlten Filme werden im allgemeinen zwischen 5 Sekunden und 2 Minuten bei Temperaturen zwischen 60 und 100°C ausgeheizt. Die so behandelten Filme lassen sich dann mit handelsüblichen alkalischen, gegebenenfalls zusätzlich Alkohole enthaltenden Entwicklern entwickeln, wobei sich die belichteten Bereiche selektiv ablösen, während in den unbelichteten Bereichen nur wenig Abtrag stattfindet.

Die in den Beispielen und Vergleichsbeispielen genannten Teile und Prozente sind, soweit nicht anders angegeben, Gewichtsteile und Gewichtsprozente.

### Beispiel 1:

Eine Fotoresistlösung wird aus 1,5 Teilen Tris-(4-t-butoxi-carbonyloxiphenyl-)sulfoniumhexafluoroarsenat, 1,5 Teilen eines Novolaks auf Basis von p-Kresol-Formaldehyd (Ep. 78,5°C) mit einem mittleren Molekulargewicht von 430 g/mol, 7,0 Teilen Poly-p-hydroxystyrol mit einem mittleren Molekulargewicht von 16 000 und 30 Teilen Methyl-propylenglykol-acetat hergestellt. Die Lösung wird anschließend durch ein Filter mit einem Porendurchmesser von 0,2 µm filtriert.

Die Extinktion einer 1 µm dicken Schicht bei 248 nm beträgt 0,79. Die Resistlösung wird auf einen einen SiO₂-Film tragenden Siliziumwafer mit 4 600 Umdrehungen/Minute aufgeschleudert, wobei eine Schichtdicke von 1,08 µm erhalten wird. Der Wafer wird während 5 Minuten bei 80°C getrocknet und anschließend mit einer bildmäßig strukturierten Testmaske in Kontakt gebracht und 10 Sekunden mit Excimer-Laserlicht der Wellenlänge 248 nm belichtet. Danach wird 30 Sekunden bei 100°C ausgeheizt und mit einem alkalischen Entwickler vom pH-Wert 13,12 60 Sekunden entwickelt. Die belichteten Bereiche sind vollständig abgelöst, während der Abtrag an den unbelichteten Stellen weniger als 5% beträgt. Die Resistmuster zeigen eine Auflösung kleiner 1 µm. Die Resistmuster zeigen ohne weitere Nachbehandlung beim Aufheizen bis 160°C kein Verfließen der Strukturen.

### Vergleichsbeispiel 1 (Resistformulierung ohne Novolakzusatz)

Eine Fotoresistlösung wird aus 1,5 Teilen Tris-(4-t-butoxi-carbonyloxiphenyl-) sulfonium-hexafluoroarsenat, 8,5 Teilen Poly-p-hydroxy-styrol mit einem mittleren Molekulargewicht von 16 000 und 30 Teilen Methyl-propylen-glykol-acetat hergestellt. Die Lösung wird anschließend durch ein Filter mit einem Porendurchmesser von 0,2 µm filtriert.

Die Extinktion einer 1 µm dicken Schicht bei 248 nm beträgt 0,78. Die Resistlösung wird dann auf einen einen SiO₂-Film tragenden Siliziumwafer mit 5 500 Umdrehungen/Minute aufgeschleudert, wobei eine Schichtdicke von 0,99 µm erhalten wird. Der Wafer wird während 5 Minuten bei 80°C getrocknet und anschließend mit einer bildmäßig strukturierten Testmaske in Kontakt gebracht und 10 Sekunden mit Excimer-Laserlicht der Wellenlänge 248 nm belichtet. Danach wird 30 Sekunden bei 100°C ausgeheizt und mit einem alkalischen Entwickler vom pH-Wert 13,12 60 Sekunden entwickelt. Die belichteten Bereiche sind vollständig abgelöst, jedoch beträgt der Abtrag der unbelichteten Stellen etwa 50%.

### Vergleichsbeispiel 2 (Resistformulierung ohne Poly-p-hydroxy-styrol)

Eine Photoresistlösung wird aus 1,5 Teilen Tris-(4-t-butoxi-carbonyloxiphenyl-) sulfonium-hexafluoroarsenat, 8,5 Teilen eines Novolaks auf Basis von p-Kresol-Formaldehyd mit einem mittleren Molekulargewicht von 430 g/mol und 20 Teilen Methyl-propylen-glykol-acetat hergestellt.

Die Lösung wird anschließend durch ein Filter mit einem Porendurchmesser von 0,2 µ filtriert.

Die Extinktion einer 1 µm dicken Schicht bei 248 nm beträgt 0,86. Die Resistlösung wird dann auf einen einen SiO₂-Film tragenden Siliziumwafer mit 3 000 Umdrehungen/Minute aufgeschleudert, wobei eine Schichtdicke von 1,02 µm erhalten wird. Der Wafer wird während 5 Minuten bei 80°C getrocknet, anschließend mit einer bildmäßig strukturierten Testmaske in Kontakt gebracht und 10 Sekunden mit Excimer-Laserlicht der Wellenlänge 248 nm belichtet. Danach wird 30 Sekunden bei 100°C ausgeheizt und mit einem alkalischen Entwickler vom pH-Wert 13,12 60 Sekunden entwickelt. Die belichteten Bereiche sind vollständig abgelöst, der Abtrag der unbelichteten Stellen beträgt weniger als 5%. Die Resistmuster beginnen jedoch schon ab 120°C zu fließen.

### Beispiele 2-4

Es wird wie in Beispiel 1 verfahren, jedoch werden anstatt 1,5 Teilen des Novolaks auf Basis von p-Kresol mit einem Erweichungspunkt (Ep) 78.5°C nach DIN 52011, jeweils 1,5 Teile der Novolake auf Basis von p-Kresol-Formaldehyd mit Erweichungspunkten 110°C (Beispiel 2), 121°C (Bsp. 3) und 133°C (Bsp. 4) eingesetzt. Es werden ebenfalls gute Resistmuster erhalten, wobei der Abtrag in den unbelichteten Bereichen kleiner als 2% ist.

## Patentansprüche

1. Strahlungsempfindliches Gemisch, das
(a) ein in Wasser unlösliches, in wäßrig-alkalischen Lösungen lösliches oder zumindest dispergierbares Bindemittel und
(b) eine organische Verbindung, deren Löslichkeit in einem wäßrig-alkalischen Entwickler durch Einwirkung von Säure erhöht wird und die mindestens eine durch Säure spaltbare Gruppierung, sowie zusätzlich eine weitere Gruppierung, die unter der Einwirkung von Strahlung eine starke Säure erzeugt, enthält,
dadurch gekennzeichnet, daß das polymere Bindemittel (a) ein Gemisch aus einem Bindemittel auf Basis von Polyvinylphenolen mit einem Molekulargewicht im Bereich von 1 000 bis 250 000 und einem Harz vom Novolaktyp im Molekulargewichtsbereich von 300 bis 20 000 enthält, und die organische Verbindung (b) ein Sulfoniumsalz der allgemeinen Formel (I) ist 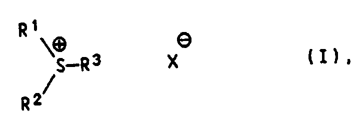 worin R¹ bis R³ untereinander gleich oder verschieden sind und für aliphatische und/oder aromatische Reste, die gegebenenfallS Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält und X^{⊖} ein nichtnucleophiles Gegenion bedeutet.

2. Strahlungsempfindliches Gemisch nach Anspruch 1, dadurch gekennzeichnet, daß das Bindemittel auf Basis von Polyvinylphenolen der Komponente (a) Poly-(p-hydroxistyrol), Poly-(p-hydroxi-α-methylstyrol) oder ein Copolymeres von p-Hydroxystyrol und p-Hydroxy-α-methylstyrol ist.

3. Strahlungsempfindliches Gemisch nach Anspruch 1, dadurch gekennzeichnet, daß das Harz von Novolaktyp der Komponente (a) ein p-Alkylphenol/Formaldehyd-Novolakharz oder ein überwiegend o,o'-verknüpftes Phenol/Formaldehyd-Novolakharz ist.

4. Strahlungsempfindliches Gemisch nach einem der vorhergehenden Ansprüche, dadurch gekennzeichnet, daß das Gemisch enthält,
(a₁) 40 bis 90 Gew.% des phenolischen Polymerisats,
(a₂) 5 bis 40 Gew.% eines Harzes vom Novolaktyp,
(b) 5 bis 20 Gew.% eines Sulfoniumsalzes der Formel (I)
mit der Maßgabe, daß die Summe der unter
(a₁) + (a₂) + (b)
genannten Prozentzahlen 100 ist, und der Feststoffgehalt des Gemisches in einem organischen Lösungsmittel zwischen 5 und 40 Gew.% liegen kann.

5. Verfahren zur Herstellung von Reliefmustern und Reliefbildern, dadurch gekennzeichnet, daß man als lichtempfindliche Beschichtungsmaterialien ein strahlungsempfindliches Gemisch nach einem der vorhergehenden Ansprüche einsetzt und nach der Belichtung gegebenenfalls auf Temperaturen zwischen 60 und 120°C erhitzt.

## Claims

1. A radiation-sensitive mixture which contains
(a) a water-insoluble binder which is soluble or at least dispersible in aqueous alkaline solutions and
(b) an organic compound whose solubility in an aqueous alkaline developer is increased by the action of an acid and which contains one or more acid-cleavable groups and in addition a further group which produces a strong acid on exposure to radiation,
wherein the polymeric binder (a) contains a mixture of a binder based on a polyvinylphenol having a molecular weight of from 1,000 to 250,000 and a resin of the novolak type having a molecular weight of from 300 to 20,000, and the organic compound (b) is a sulfonium salt of the general formula (I) 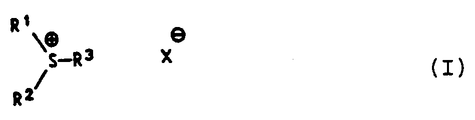 where R¹ to R³ are identical or different and are aliphatic and/or aromatic radicals which may contain heteroatoms, or two of the radicals R¹ to R³ are bonded to one another to form a ring, with the proviso that one or more of the radicals R¹ to R³ contain one or more acid-cleavable groups, and X^{⊖} is a non-nucleophilic counter-ion.

2. A radiation-sensitive mixture as claimed in claim 1, wherein the binder based on a polyvinylphenol of component (a) is poly(p-hydroxystyrene), poly-(p-hydroxy-α-methylstyrene) or a copolymer of p-hydroxystyrene and p-hydroxy-α-methylstyrene.

3. A radiation-sensitive mixture as claimed in claim 1, wherein the resin of the novolak type of component (a) is a p-alkylphenol/formaldehyde novolak resin or a predominantly o,o'-bonded phenol/formaldehyde novolak resin.

4. A radiation-sensitive mixture as claimed in any of the preceeding claims, which contains
(a₁) from 40 to 90% by weight of the phenolic polymer,
(a₂) from 5 to 40% by weight of a resin of the novolak type and
(b) from 5 to 20% by weight of a sulfonium salt of the formula (I),
with the proviso that the sum of the percentages stated under (a₁), (a₂) and (b) is 100, and the solids content of the mixture in an organic solvent may be from 5 to 40% by weight.

5. A process for the production of a relief pattern or relief image, wherein a radition-sensitive mixture as claimed in any of the preceeding claims is used as the photosensitive coating material and, after exposure, may be heated to 60-120°C.

## Revendications

1. Mélange sensible aux rayonnements, qui contient
(a) un liant insoluble dans l'eau mais soluble ou au moins dispersable dans les solutions aqueuses alcalines, et
(b) un composé organique dont la solubilité dans un révélateur aqueux alcalin est accrue sous l'action d'un acide et qui contient au moins un groupement scindable par les acides et également un autre groupement qui produit un acide fort sous l'action des rayonnements,
caractérisé en ce que le liant polymère a) contient un mélange d'un liant à base de polyninylphénols de poids moléculaire 1000 à 250 000 et d'une résine du type novolaque d'un poids moléculaire de 300 à 20 000, et le composé organique b) est un sel de sulfonium de formule générale I 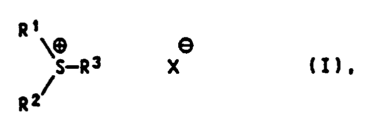 dans laquelle R¹ à R³, ayant des significations indentiques ou différentes, représentent des radicaux aliphatiques et/ou aromatiques contenant le cas échéant des hétéroatomes, ou bien deux des groupes R¹ à R³ sont reliés entre eux avec formation d'un cycle, sous réserve que l'un au moins des radicaux R¹ à R³ contient au moins un groupement scindable par les acides, et X^{⊖} représente un on correspondant non nucléophile.

2. Mélange sensible aux rayonnements selon la revendication 1, caractérisé en ce que le liant à base de polyvinylphénols du composant a) consiste en un poly-(p-hydroxystyrène), un poly-(p-hydroxy-alpha-méthylstyrène) ou un copolymère du p-hydroxy-styrène et du p-hydroxy-alpha-méthylstyrène.

3. Mélange sensible aux rayonnements selon la revendication 1, caractérisé en ce que la résine du type novolaque du composant a) est une résine novolaque p-alkylphénol/formaldéhyde ou une résine novolaque phénol/formaldéhyde à liaisons principales o,o'.

4. Mélange sensible aux rayonnements selon l'une des revendications qui précèdent, caractérisé en ce que le mélange contient :
(a₁) 40 à 90 % en poids du polymère phénolique,
(a₂) 5 à 40 % en poids d'une résine du type novolaque,
(b) 5 à 20 % en poids d'un sel de sulfonium de formule I,
la somme des pourcentages indiqués pour
(a₁) + (a₂) + (b)
étant égale à 100, et la teneur en matières solides du mélange dans un solvant organique pouvant aller de 5 à 40 % en poids.

5. Procédé pour la fabrication de modèles en relief et images en relief, caractérisé en ce que l'on utilise en tant que matériau de revêtement photosensible un mélange sensible aux rayonnements selon une des revendications qui précèdent, et après exposition à la lumière, le cas échéant, on le chauffe à des températures de 60 à 120 °C.
